(19) **Europäisches Patentamt / European Patent Office / Office européen des brevets**

(11) **EP 3 358 246 A1**

(12) **EUROPEAN PATENT APPLICATION**
published in accordance with Art. 153(4) EPC

(43) Date of publication:
**08.08.2018 Bulletin 2018/32**

(21) Application number: **16851946.0**

(22) Date of filing: **03.10.2016**

(51) Int Cl.:
*F21S 2/00* (2016.01)    *F21V 8/00* (2006.01)
*F21V 29/503* (2015.01)    *G02B 5/10* (2006.01)
*G02B 6/00* (2006.01)    *G02B 17/08* (2006.01)
*H01L 33/00* (2010.01)    *H01L 33/58* (2010.01)
*H01L 33/60* (2010.01)    *F21Y 115/10* (2016.01)

(86) International application number:
**PCT/JP2016/079360**

(87) International publication number:
**WO 2017/057777 (06.04.2017 Gazette 2017/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **01.10.2015 JP 2015195886**

(71) Applicant: **Kabushiki Kaisha Toshiba**
**Minato-ku**
**Tokyo 105-8001 (JP)**

(72) Inventors:
• **HAYASHIHARA Hiromichi**
**Tokyo 105-8001 (JP)**
• **OHNO Hiroshi**
**Tokyo 105-8001 (JP)**
• **SUZUKI Tomoyuki**
**Tokyo 105-8001 (JP)**
• **TAKAMATSU Tomonao**
**Tokyo 105-8001 (JP)**
• **MORINO Takeshi**
**Tokyo 105-8001 (JP)**

(74) Representative: **Hoffmann Eitle**
**Patent- und Rechtsanwälte PartmbB**
**Arabellastraße 30**
**81925 München (DE)**

(54) **OPTICAL ELEMENT AND LED LIGHTING DEVICE**

(57) An optical element according to an embodiment includes: an incident surface facing a light source; a side surface intersecting with the incident surface; and a recessed surface facing the incident surface and intersecting with the side surface, the recessed surface having a shape protruding toward the incident surface, wherein the recessed surface includes: a first surface through which a central axis connecting a central portion of the incident surface and a central portion of the recessed surface extends; a second surface joined to the first surface; and a third surface joined to the second surface and to the side surface, and r represents a distance from the central portion of the incident surface to a rim of the incident surface, n represents a refractive index of the optical element, and a distance L from the recessed surface to the incident surface along the central axis satisfies the following condition:

$$L \geq \frac{2r}{\sqrt{n^2-1}}$$

FIG.2

**Description**

FIELD

Embodiments described herein relate generally to an optical element and an LED lighting device.

BACKGROUND

An LED lighting device for general lighting is sometimes expected to have a shape like an incandescent bulb and emits light like an incandescent bulb. That is, retrofitting is sometimes desired. Particularly, there is often a demand for wide light distribution from a point light source inside a globe as in a case with a clear incandescent bulb, such as an incandescent bulb having a globe formed with clear glass. For example, there is a demand for lighting of approximately 270 degrees in 1/2 light distribution angle. However, if an LED is used as a light source, the light distribution angle becomes narrower, and the 1/2 light distribution angle decreases to approximately 120 degrees. In view of this, the light distribution angle may be widened with an optical element, such as a wide distribution lens.

An optical element like the one described above is known (US 6350041B1). This optical element has a scattering member at the top edge of a light guiding rod. An LED is provided on the bottom surface of the light guiding rod facing the scattering member. Light emitted from the LED propagates in the light guiding rod through total reflection, and is guided to the scattering member. The light that has reached the scattering member is diffusely reflected by the scattering member, and is emitted to the outside. In this manner, an LED bulb that distributes light uniformly from the center of the bulb like a filament bulb can be obtained.

However, the luminance of light diffusely reflected by a scatterer as in conventional cases becomes lower. The decrease in the luminance results in disfigurement of the light source. For this reason, it is desirable to prevent or reduce the decrease in luminance.

SUMMARY OF THE INVENTION

Technical Problem

This embodiment provides an optical element and an LED lighting device that can reduce decreases in luminance.

An optical element according to an embodiment includes: an incident surface facing a light source; a side surface intersecting with the incident surface; and a recessed surface facing the incident surface and intersecting with the side surface, the recessed surface having a shape protruding toward the incident surface, wherein the recessed surface includes: a first surface through which a central axis connecting a central portion of the incident surface and a central portion of the recessed surface extends; a second surface joined to the first surface; and a third surface joined to the second surface and to the side surface, and r represents a distance from the central portion of the incident surface to a rim of the incident surface, n represents a refractive index of the optical element, and a distance L from the recessed surface to the incident surface along the central axis satisfies the following condition:

$$L \geq \frac{2r}{\sqrt{n^2 - 1}}$$

BRIEF DESCRIPTION OF THE DRAWINGS

FIG. 1 is a perspective view showing an LED lighting device according to a first embodiment.
FIG. 2 is a cross-sectional view showing a light guiding rod of the first embodiment.
FIG. 3A is a cross-sectional view showing a light guiding rod according to a first modification of the first embodiment.
FIG. 3B is a cross-sectional view showing a light guiding rod according to a second modification of the first embodiment.
FIG. 3C is a cross-sectional view showing a light guiding rod according to a third modification of the first embodiment.
FIG. 3D is a cross-sectional view showing a light guiding rod according to a fourth modification of the first embodiment.
FIG. 3E is a cross-sectional view showing a light guiding rod according to a fifth modification of the first embodiment.
FIG. 4 is a cross-sectional view showing a light guiding rod of a second embodiment.
FIG. 5 is a photograph showing the side surface of an LED lighting device according to a third embodiment.
FIG. 6 is a cross-sectional view of the LED lighting device according of the third embodiment.
FIG. 7 is a diagram showing a light distribution of the LED lighting device of the third embodiment.
FIG. 8 is a cross-sectional view for explaining a critical ray in the light guiding rod of the first embodiment.
FIG. 9 is a diagram for explaining the effects of a light guiding rod according to the second modification of the first embodiment.
FIG. 10 is a side view showing a portion around the recessed surface of a light guiding rod according to a sixth modification of the first embodiment.
FIG. 11 is a cross-sectional view taken along a plane including the central axis of a light guiding rod according to a seventh modification of the first embodiment.

## DETAILED DESCRIPTION

The following is a detailed description of embodiments, with reference to the accompanying drawings.

(First Embodiment)

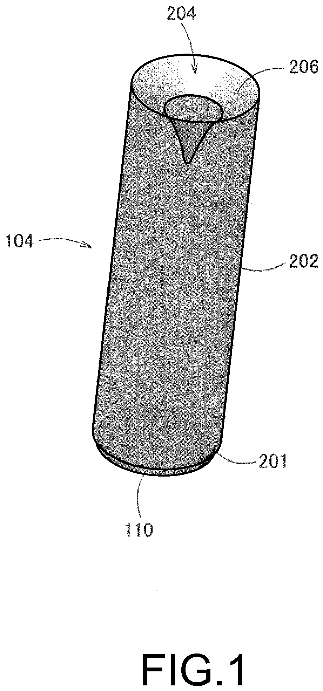

FIG. 1 shows a perspective view of a light emitting diode (LED) lighting device according to a first embodiment. The LED lighting device of this embodiment includes an optical element (such as a light guiding rod) 104 and an LED 110. In the following description, a light guiding rod will be described as an example of the optical element.

The light guiding rod 104 is made of a transparent material having a refractive index n. Specifically, the light guiding rod 104 is made of a resin such as polymethylmethacrylate (PMMA), polycarbonate (PC), or glass or the like. The light guiding rod 104 includes an incident surface 201 that faces the LED 110 and receives light from the LED 110, a side surface 202 that intersects with the incident surface 201 along the normal direction of the incident surface 201, and a recessed surface 204 that faces the incident surface 201 and intersects with the side surface 202. The recessed surface 204 has a shape that protrudes toward the incident surface 201. The incident surface 201 and the side surface 202 of the light guiding rod 104 are smooth surfaces.

Part of the recessed surface 204 may be coated with a reflecting member 206 that reflects light. However, the reflecting member 206 is not necessarily provided, and the LED lighting device of this embodiment properly functions without the reflecting member 206. The reflecting member 206 is formed by vapor deposition of a metal such as aluminum, glossy coating, or the like.

The central axis of the light guiding rod 104 extends in a direction parallel to the side surface 202, and a direction from the incident surface 201 toward the recessed surface 204 is the positive direction. The shape of the light guiding rod 104 is rotationally symmetrical, for example.

Here, being rotationally symmetrical means that, when the object is rotated about the rotation axis, the rotation angle is smaller than 360 degrees to match the original shape. However, the shape is not necessarily a rotationally symmetrical shape. In a case where the shape is rotationally symmetrical, the central axis of the light guiding rod 104 coincides with the axis of rotational symmetry.

(The Shape of the Recessed Surface 204)

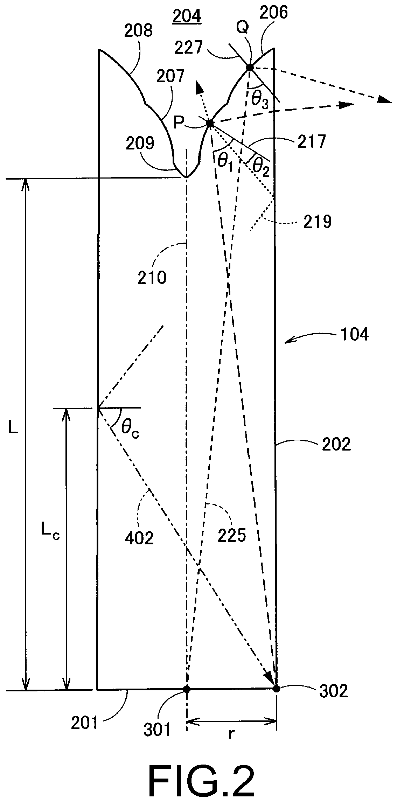

FIG. 2 is a cross-sectional view of the light guiding rod 104, including the central axis 210. The recessed surface 204 includes a first surface 209 that intersects with the central axis 210, a second surface 207 joined to the first surface 209, a third surface 208 joined to the second surface 207 and the side surface 202. The third surface 208 may be coated with the reflecting member 206. However, the third surface 208 is not necessarily coated with the reflecting member 206.

The first surface 209 has such a shape that the first surface 209 becomes closer to the incident surface 201 in the direction from its rim toward the central axis 210.

An arbitrary point on the second surface 207 is set as a point P. At the point P, an angle between a vector from the point P toward a second point 302 on the rim of the incident surface 201 and an inward normal vector 217 from the point P toward the inside of the light guiding rod 104 (inward) is represented by $\theta_1$. The total reflection angle $\theta_c$ of the light guiding rod 104 can be expressed as follows using the refractive index n of the light guiding rod 104.

$$\theta_C = \arcsin\left(\frac{1}{n}\right) \qquad (1)$$

At this time, the second surface 207 is formed so as to include a region in which the following condition is satisfied:

$$\theta_1 \geq \theta_c \qquad (2)$$

A reversed ray vector 219 formed by reversing (temporally reversing) the ray direction vector of a light ray that enters the incident surface 201 from the LED 110, is totally reflected by the side surface 202 of the light guiding rod 104, and reaches the point P, and the inward normal vector 217 at the point P is represented by $\theta_2$. In this case, the second surface 207 is formed so that there exists at least a light ray satisfying the condition shown in the following expression (3).

$$\theta_2 < \theta_c \qquad (3)$$

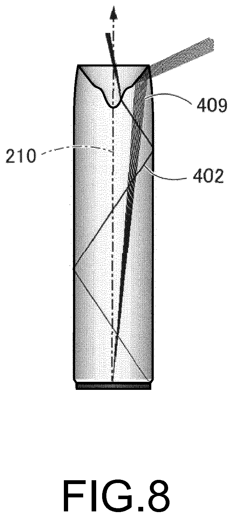

In this embodiment, the angle between a vector parallel to the incident surface 201 and a light ray satisfying the condition shown in the above expression (3) is the critical angle for the light ray. Here, the critical angle is equal to the total reflection angle $\theta_c$. For this reason, the critical ray 402 shown in FIG. 2 is an example of a light ray satisfying the condition shown in the above expression (3). The critical ray 402 is emitted from the second point 302 on the rim of the incident surface 201, and is totally reflected by the side surface 202. Alternatively, the critical ray 402 may be emitted from a point other than the second point 302 on the rim of the incident surface 201. FIG. 8 shows the critical ray 402 of the optical element of this embodiment in a plane including the central axis 210.

An arbitrary point on the third surface 208 is set as a point Q. The center of the incident surface 201 (the point through which the central axis 210 extends) is set as a first point 301. At the point Q, the angle between a vector 225 from the point Q toward the first point 301 and an inward normal vector 227 of the point Q is represented by $\theta_3$. In this case, the third surface 208 is formed so as to satisfy the condition shown in the following expression (4).

$$\theta_3 \geq \theta_c \qquad (4)$$

The third surface 208 is also joined to the side surface 202 of the light guiding rod 104. The second surface 207 and the third surface 208 have at least a pair of normal lines that are different from each other. With this, it is possible to achieve different characteristics on the respective surfaces from one another, with respect to the directions of light rays that are reflected by or pass through the respective surfaces. Where $L_c$ represents the minimum value of the length L along the central axis 210 from the incident surface 201 to the recessed surface 204, and r represents the distance from the first point to the second point, $L_c$ is defined as:

$$L_c = 2r \times \tan\theta_c \qquad (5)$$

Therefore, the length L is expressed as follows:

$$L \geq L_c \qquad (6)$$

That is, the length L is designed to satisfy the condition shown in the following expression.

$$L \geq 2r \tan\theta_C = \frac{2r}{\sqrt{n^2 - 1}} \qquad (7)$$

The side surface 202 has a shape that becomes narrower or remains the same in the direction from the rim of the incident surface 201 toward the rim of the recessed surface 204. Here, the same shape means that cross-sections taken along planes perpendicular to the central axis 210 are the same in the direction from the rim of the incident surface 201 to the rim of the recessed surface 204.

(Functions of Components)

Next, the functions of the respective components of the first embodiment are described.

The LED 110 is supplied with electric power from a power supply and an electric cable (not shown), and performs surface light emission. That is, the LED 110 is a surface light source. Light from the LED 110 is refracted by the incident surface of the light guiding rod 104, and enters the light guiding rod 104. At this stage, the maximum value of the incident angle is the critical angle, which is the total reflection angle. The light rays that have entered the light guiding rod 104 propagate while being totally reflected by the side surface 202 in a repetitive manner.

Of the light rays incident on the second point 302 of the incident surface 201 from the LED 110, those that directly reach the second surface 207 satisfy the condition shown in the expression (2), and thus, are totally reflected. Further, the light rays are refracted by the side surface 202, and are emitted to the outside of the light guiding rod 104. Meanwhile, of the light rays that have entered from an arbitrary point on the incident surface 201, those that directly reach the second surface 207 satisfy the condition shown in the expression (2), so that the angle $\theta_1$ between the inward normal vector 217 at the arrival point P and the reversed ray direction vector is larger than the total reflection angle $\theta_c$. Because of this, these light rays are also totally reflected by the second surface 207, are further refracted by the side surface 202, and are emitted to the outside of the light guiding rod 104.

In the above manner, a light ray component that has a narrow light distribution angle, enters the light guiding rod 104 from the LED 110, and propagates along the central axis 210 is transformed into a light ray component having a wide light distribution angle. Here, the light distribution angle is the angle between the directional vector of the central axis 210 and the ray direction vector. Also, as the total reflection by the recessed surface 204 does not involve diffusion of light, the luminance of each light ray is maintained. In other words, it is possible to achieve the effect of reducing luminance loss. Further, since total reflection causes little energy loss, it is possible to achieve the effect of realizing a high light usage efficiency. In practice, in a case where the condition shown in the expression (4) is satisfied, a light ray 409 emitted from the first point 301 directly reaches the third surface 208, is totally internally reflected (totally reflected), and is emitted to the outside, as shown in FIG. 8.

Of the light rays incident on the first point 301, those that directly reach the third surface 208 satisfy the condition shown in the expression (4), and thus, are totally reflected. Further, the light rays are refracted by the side surface 202, and are emitted to the outside of the light guiding rod 104. Meanwhile, of the light rays that have entered the region from the first point 301 to a point at the rim on the opposite side from the second point 302 on the incident surface 201, those that directly reach the third surface 208 satisfy the condition shown in the expression (4), so that the angle $\theta_3$ between the inward normal vector 227 at the arrival point Q and the reversed ray direction vector 225 is equal to or larger than the total

reflection angle $\theta_c$. Because of this, these light rays are also totally reflected by the third surface 208, are further refracted by the side surface 202, and are emitted to the outside of the light guiding rod 104.

In the above manner, a light ray component that has a narrow light distribution angle, enters the light guiding rod 104 from the LED 110, and propagates along the central axis 210 is transformed into a light ray component having a wide light distribution angle. Also, as the total reflection by the recessed surface 204 does not involve diffusion of light, the luminance of each light ray is maintained. In other words, it is possible to achieve the effect of reducing luminance loss. Further, since total reflection causes little energy loss, it is possible to achieve the effect of realizing a high light usage efficiency.

In a case where the third surface 208 is coated with the reflecting member 206, all light rays that enter the incident surface 201 and reach the third surface 208 are reflected. That is, in this case, the light ray component having a narrow light distribution angle transformed into a wide light distribution angle is increased. In other words, it is possible to achieve the effect of widening light distributions.

Of the light rays that have entered from the incident surface 201, the light rays that are totally reflected by the side surface of the light guiding rod 104 in a repetitive manner, and reach the second surface 207 satisfy the condition shown in the expression (3), and are thus partially or totally transmitted, and are then emitted to the outside. As a result, it is possible to generate a light ray component emitted along the central axis 210 from the recessed surface 204 at the top edge of the light guiding rod 104. This component is generated mainly from light rays that have entered the incident surface 201 at a critical angle (total reflection angle) or an incident angle similar to the critical angle. Satisfying the condition shown in the expression (7), such light rays are refracted through total reflection by the side surface 202, and reach the second surface 207.

As described above, light rays emitted from the LED 110 enter the light guiding rod 104 from the incident surface 201, and are guided to the recessed surface 204 provided at the top edge of the light guiding rod 104. The light rays are then emitted in all directions from the recessed surface 204. Because of this, it is possible to achieve the effect of increasing the 1/2 light distribution angle, or obtaining a wide light distribution.

Also, as the total reflection by the recessed surface 204 does not involve diffusion of light, the luminance of each light ray is maintained. In other words, it is possible to achieve the effect of emitting light rays in all directions, without any luminance loss.

Further, since the total reflection causes little energy loss, it is possible to achieve the effect of realizing a high light usage efficiency.

The first surface 209 can convert a light ray component having a narrow light distribution angle into a light ray component having a wide light distribution angle by virtue of a concave lens effect. Thus, it is possible to achieve the effect of widening light distributions.

Almost all the light rays that are reflected by the recessed surface 204 and return to the LED 110 are absorbed by the LED 110. This is the main cause of a decrease in light usage efficiency. Therefore, it is desirable to reduce such return light. The return light reflected by the recessed surface 204 is totally reflected by the side surface 202, reaches the incident surface 201, and then enters the LED 110. Alternatively, the return light directly reaches the incident surface 201, and enters the LED 110.

In a case where the condition shown in the expression (7) is satisfied, it is possible to obtain the critical ray 402 that enters the side surface 202 at the critical angle, is totally reflected, and then reaches the second point 302. In this case, all the return light that enters from the recessed surface 204 toward the side surface 202 at a smaller angle than the critical angle reaches the side surface 202, and is transmitted.

In a case where the condition shown in the expression (7) is not satisfied, on the other hand, part of the return light entering from the recessed surface 204 toward the side surface 202 at a smaller angle than the critical angle might directly reach the incident surface 201, and enter the LED 110.

As described above, where the condition shown in the expression (7) is satisfied, all the return light that enters from the recessed surface 204 toward the side surface 202 at a smaller angle than the critical angle passes through the side surface 202. Accordingly, the light rays to be absorbed by the LED 110 can be reduced. In other words, it is possible to achieve the effect of increasing the light usage efficiency.

The side surface 202 has a shape that becomes narrower in the direction from the rim of the incident surface 201 toward the rim of the recessed surface 204, or has the same cross-sectional shape toward the rim. Such a shape can be formed with a metal mold, and thus, it is possible to achieve the effect of increasing mass productivity.

(First Modification)

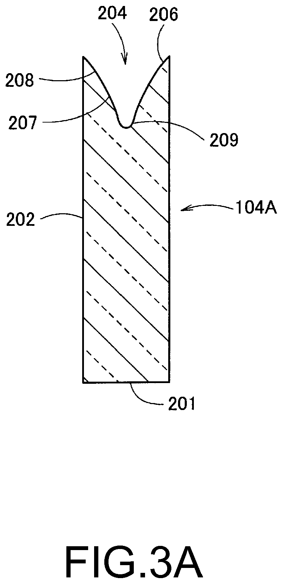

Referring now to FIG. 3A, an LED lighting device according to a first modification of the first embodiment is described.

The LED lighting device of the first modification has the same structure as the LED lighting device of the first embodiment, except that the light guiding rod 104 is replaced with a light guiding rod 104A shown in FIG. 3A.

The light guiding rod 104A is the same as the light guiding rod 104 shown in FIG. 2, except that the first surface 209 and the second surface 207 are smoothly joined to each other. With this design, a surface treatment can be easily performed to smooth the recessed surface 204.

Further, in the first modification, the first surface 209 and the second surface 207 are in a mirror surface state, which is an uncoated state, and the third surface 208 is coated with a reflecting member 206 that is white and glossy. The incident surface 201 is in a mirror surface state, as in the light guiding rod 104 of the first embodiment.

(Second Modification)

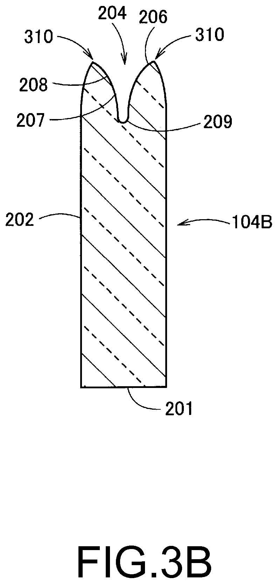

Referring now to FIG. 3B, an LED lighting device according to a second modification of the first embodiment is described.

The LED lighting device of the second modification has the same structure as the LED lighting device of the first embodiment or the first modification, except that the light guiding rod 104 or 104A is replaced with a light guiding rod 104B shown in FIG. 3B.

The light guiding rod 104B is the same as the light guiding rod 104 or 104A shown in FIG. 2 or 3A, except that a tip portion 310 or a portion in the vicinity of the region where the third surface 208 and the side surface 202 intersect with each other has such a shape that the portion becomes narrower in the direction toward the top edge. In this case, the punching process using a metal mold can be facilitated.

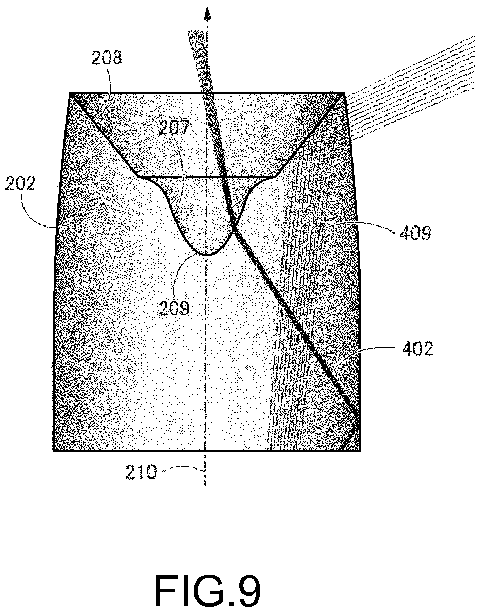

As shown in FIG. 9, since the side surface 202 has such a shape that becomes narrower in the direction toward the top edge, reflection of a light ray 409 by the side surface 202 can be reduced when the light ray 409 is reflected by the surface 208 and reaches the side surface 202. That is, as shown in FIG. 9, the outward normal line (the normal line extending to the outside) of the second surface 207 is designed so that the angle to the central axis 210 becomes smaller as the distance from the first surface 209 becomes longer. This is because the angle of incidence of the light ray 409 with respect to the side surface 202 is small due to the shape that becomes narrower in the direction toward the top edge. That is, according to the theory of Fresnel reflection, as the incident angle becomes smaller, the reflection component decreases, and the transmission component increases. In a case where the side surface 202 does not have a shape that becomes narrower in the direction toward the top edge, on the other hand, as the component of re-reflection by the side surface 202 increases, the light absorption by the optical element 104 of the present embodiment increases, and light ray loss occurs.

(Third Modification)

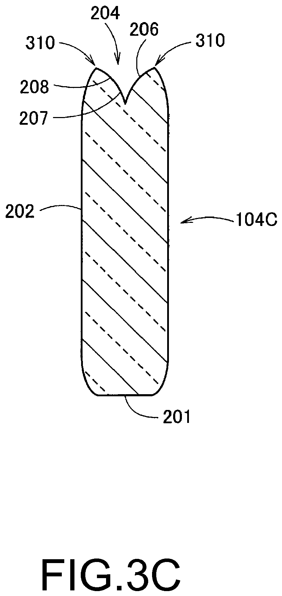

Referring now to FIG. 3C, an LED lighting device according to a third modification of the first embodiment is described.

The LED lighting device of the third modification has the same structure as any of the LED lighting devices of the first embodiment and the first and second modifications, except that the light guiding rod 104, 104A, or 104B is replaced with a light guiding rod 104C shown in FIG. 3C.

The light guiding rod 104C of the third modification has the same structure as any of the light guiding rods 104, 104A, and 104B, except that the first surface 209 is eliminated. That is, the recessed surface 204 is formed with the second surface 207 and the third surface 208. In FIG. 3C, the light guiding rod 104C has the same structure as the light guiding rod 104B shown in Fig. 3B, except that the first surface 209 is eliminated. In the third modification, the second surface 207 intersects with the central axis 210.

Further, as shown in FIG. 3C, the portion at which the incident surface 201 and the side surface 202 intersect with each other may be designed to become smooth.

(Fourth Modification)

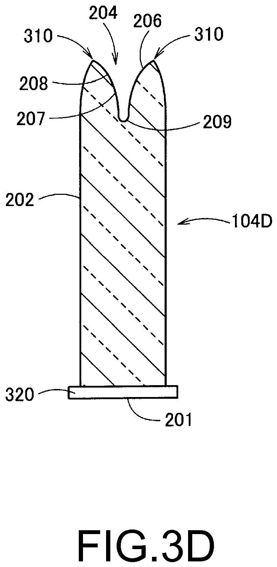

Referring now to FIG. 3D, an LED lighting device according to a fourth modification of the first embodiment is described.

The LED lighting device of the fourth modification has the same structure as any of the LED lighting devices of the first embodiment and the first, second, and third modifications, except that the light guiding rod 104, 104A, 104B, or 104C is replaced with a light guiding rod 104D shown in FIG. 3D.

The light guiding rod 104D of the fourth modification has the same structure as any of the light guiding rods 104, 104A, 104B, and 104C, except that a flange portion 320 is provided at a portion of the side surface 202 on the side of the incident surface 201. The flange portion 320 functions as an attaching portion when the light guiding rod 104D is attached to another component. In FIG. 3D, the light guiding rod 104D has the same structure as the light guiding rod 104B shown in Fig. 3B, except that the flange portion 320 is provided on the incident surface 201. As the flange portion 320 is provided, attachment of the light guiding rod 104D to a device can be facilitated.

(Fifth Modification)

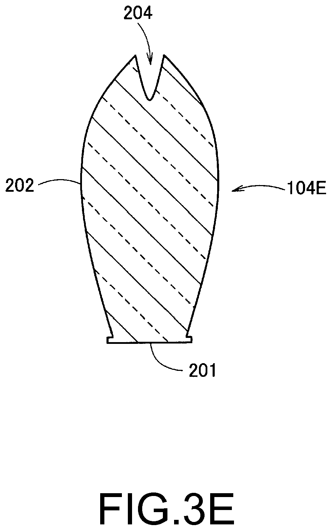

Referring now to FIG. 3E, an LED lighting device according to a fifth modification of the first embodiment is described.

The LED lighting device of the fifth modification has the same structure as any of the LED lighting devices of the first embodiment and the first, second, third, and fourth modifications, except that the light guiding rod 104, 104A, 104B, 104C, or 104D is replaced with a light guiding rod 104E shown in FIG. 3E.

The light guiding rod 104E of the fifth modification is the same as any of the light guiding rods 104, 104A, 104B, 104C, and 104D, except that the side surface 202 has a shape that is curved outward, and a cross-section of the side surface 202 taken along the central axis has a shape that becomes narrower in the direction toward the incident surface 201.

In the first embodiment and the first through fourth modifications, the side surface 202 is perpendicular to the incident surface, and therefore, a cross-section taken along a plane including the central axis of the light guiding rod has a shape that does not become narrower in the direction toward the incident surface 201. In this case, a light ray that is reflected by the recessed surface 204 and is returning to the LED 110 is totally reflected in a repetitive manner if the light ray exceeds the critical angle on the side surface 202. The light ray then returns to the LED 110, and is absorbed.

In the fifth modification, on the other hand, in a case where the side surface 202 has a shape that becomes narrower in the direction toward the incident surface 201, each light ray returning to the LED 110 has a smaller incident angle than the critical angle (total reflection angle) on the side surface 202, and is emitted to the outside. This can reduce the return light to the LED 110. Thus, the light usage efficiency can be further increased.

(Sixth Modification)

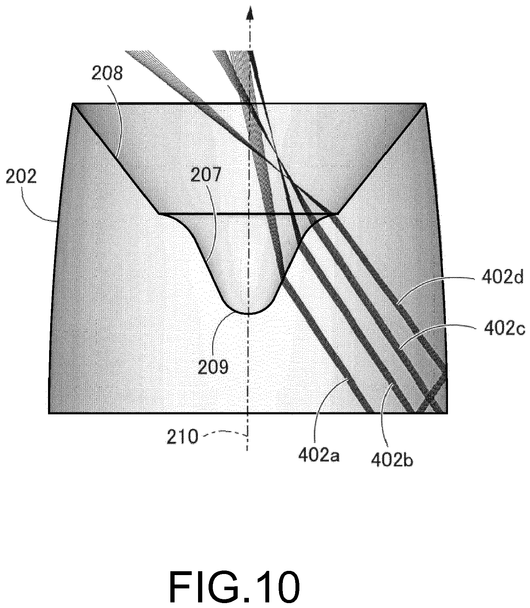

FIG. 10 shows a side view of a portion around the recessed surface of a light guiding rod according to a sixth modification. FIG. 10 also shows a light ray diagram in a plane including the central axis 210. The outward normal line (the normal line extending to the outside) of the third surface 208 is designed so that the angle to the central axis 210 becomes smaller as the distance from the first surface 209 becomes longer. With this design, light rays 402a through 402d at the critical angle with respect to the central axis 210 are refracted and transmitted by the second surface 207. The direction of refraction becomes closer to the light distribution side (the angle to the central axis becomes larger) in the order of 402a to 402d. With this design, a wide light distribution component can be generated, and at the same time, the light ray 402 can be prevented from being reflected again by the third surface 208. That is, each light ray refracted and transmitted by the second surface is refracted in such a direction that the light ray travels further away from the third surface 208, where the transmission point is closer to the first surface 209. Thus, the light ray is not reflected again by the third surface 208, and light ray absorption and reflection loss can be reduced. On the other hand, where the transmission point is at a longer distance from the first surface 209, a light ray is refracted in such a direction that the light ray travels toward the third surface 208. Thus, a wide light distribution component can be generated.

(Seventh Modification)

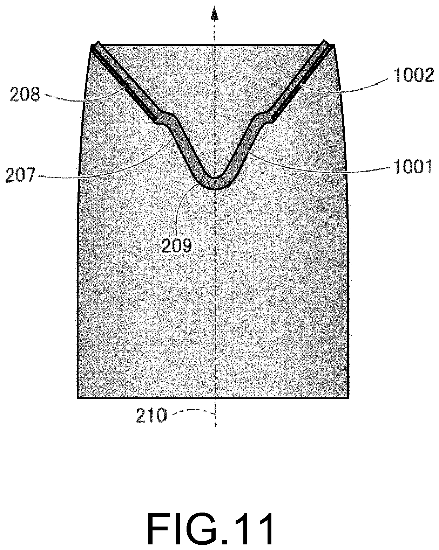

FIG. 11 is a cross-sectional view taken along a plane including the central axis 210 of a light guiding rod according to a seventh modification. In FIG. 11, a transparent coating 1001 and a reflective coating 1002 are applied to the recessed surface. The transparent coating 1001 covers the entire recessed surface and the reflective coating 1002, and functions as a protective film. The transparent coating 1001 also has a function of reducing reflection of light rays on the first surface 209 and the second surface 207. The transparent coating 1001 also has a function of reducing total reflection of a weak light ray propagating in the reflective coating 1002 on the third surface 208 from the interface formed with the reflective coating 1002 and the external environments. The transparent coating 1001 is normally made of a material having a lower refractive index than the optical element 104 of this embodiment Since the transparent coating 1001 covers the entire recessed surface, there is an advantage that masking does not need to be performed when the recessed surface is created. Furthermore, in the light guiding rod of the seventh modification, there are no components other than the transparent coating 1001 and the reflective coating 1002 on the outer surface of the recess. Thus, the heat releasing effect can be enhanced.

As described above, the first embodiment and the first through seventh modifications can provide LED lighting devices capable of reducing decreases in luminance.

(Second Embodiment)

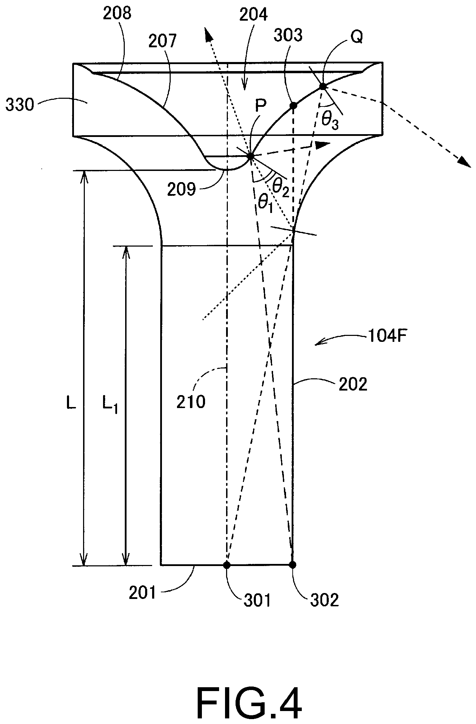

Referring now to FIG. 4, an LED lighting device according to a second embodiment is described. The LED lighting device of the second embodiment has the same structure as the LED lighting device of the first embodiment, except that the light guiding rod 104 is replaced with a light guiding rod 104F shown in FIG. 4. FIG. 4 is a cross-sectional view of the light guiding rod 104F, taken along the central axis 210. The light guiding rod 104F has the same structure as the light guiding rod 104 of the first embodiment, except that the external shape of a cross-section taken along a plane perpendicular to the central axis 210 is a round shape that has the same size in the region from the incident surface 201 to a first position at a predetermined distance $L_1$ from the incident surface 201, has a round shape that becomes larger in the region from the first position to a second position along the central axis 210, and has a round shape that has the same size in the region from the second position to the top edge of the recessed surface 204. Specifically, in the light guiding rod 104F, a flange portion 330 is provided at a portion of the side surface 202 in the vicinity of the recessed surface 204, and the shape of the recessed surface 204 is different. The recessed surface 204 extends to the side surface of the flange portion 330. The flange portion 330 and the side surface 202 are joined by a smooth, curved surface. In the second embodiment, a point at which a straight line extending from the second point 302 along the side surface 202 reaches the recessed surface 204 is defined as a third point 303.

The distance L from the recessed surface 204 to the incident surface 201 along the central axis 210 satisfies the condition shown in the expression (7), as in the first embodiment.

The above distance $L_1$ preferably satisfies the condition shown below:

$$L_1 \geq L_C \qquad (8)$$

That is, the above distance $L_1$ preferably satisfies the condition shown below:

$$L_1 \geq 2r \tan \theta_C = \frac{2r}{\sqrt{n^2 - 1}} \qquad (9)$$

As the above condition is satisfied, all the return light that enters from the recessed surface 204 toward the side surface 202 at a smaller angle than the critical angle passes through the side surface 202, as in the first embodiment. Accordingly, the light rays to be absorbed by the LED 110 can be reduced. In other words, it is possible to achieve the effect of increasing the light usage efficiency.

The recessed surface 204 includes a first surface 209 that intersects with the central axis 210, a second surface 207 joined to the first surface 209, a third surface 208 joined to the second surface 207, as in the light guiding rod 104 of the first embodiment. The rim of the second surface 207 is the third point 303. The rim of the third surface 208 is joined to the side surface 202.

As described above, the light guiding rod 104F of the second embodiment includes the flange portion 330, so that the light distribution can be controlled to be a desired distribution.

Next, the effects of the second embodiment are described.

Light rays that enter from the second point 302 on the incident surface 201 cannot directly reach the third surface 208. Therefore, it is possible to reduce the light ray component of a narrow light distribution transmitted from the third surface 208 through the second point 302. Thus, the narrow light distribution component can be reduced, and a wide light distribution can be achieved.

As described above, light rays emitted from the LED 110 enter the light guiding rod 104 from the incident surface 201, and are guided to the recessed surface 204 provided at the top edge of the light guiding rod 104. By the recessed surface 204, the light rays are reflected and transmitted, and are emitted in all directions. Because of this, it is possible to achieve the effect of increasing the 1/2 light distribution angle, or obtaining a wider light distribution. Also, as the total reflection by the recessed surface 204 does not involve diffusion of light, the luminance of each light ray is maintained. In other words, it is possible to achieve the effect of emitting light rays in all directions without any luminance loss. Further, since total reflection causes little energy loss, it is possible to achieve the effect of realizing a high light usage efficiency.

As described above, the second embodiment can provide an LED lighting device capable of preventing decreases in luminance.

(Third Embodiment)

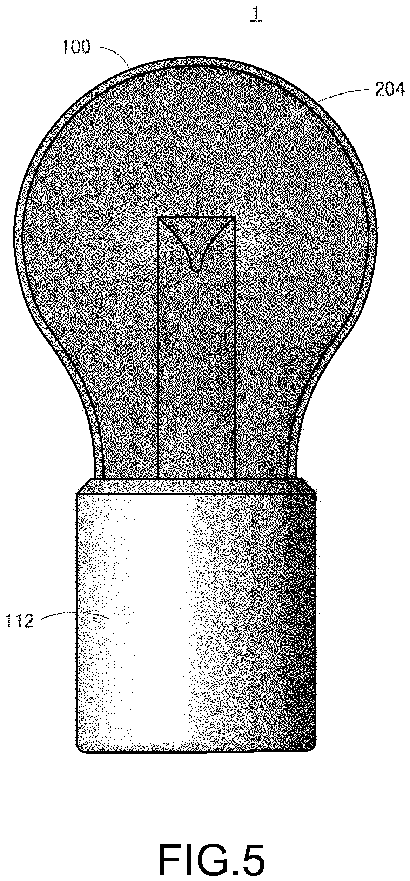

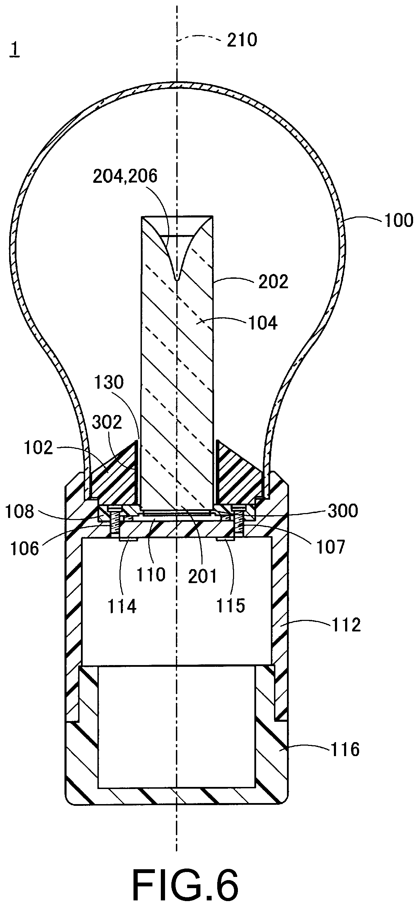

Referring now to FIGS. 5 and 6, an LED lighting device according to a third embodiment is described. FIG. 5 is a photograph showing the side surface of the LED lighting device of the third embodiment. FIG. 6 is a cross-sectional view taken along a plane extending along the central axis of the LED lighting device of the third embodiment.

The LED lighting device of the third embodiment includes the light guiding rod of one of the LED lighting devices of the first embodiment, the first through fifth modifications, and the second embodiment. In the description below, the light guiding rod will be explained as the light guiding rod 104 of the first embodiment.

The LED lighting device 1 of the third embodiment includes a globe 100, a cover (a covering portion) 102, a light guiding rod (an optical element) 104, spacer fixing screws 106 and 107, a spacer 108, an LED 110, a housing 112, cover fixing screws 114 and 115, and a cap 116. That is, the LED lighting device 1 of the third embodiment is an LED bulb. The housing 112 has a heat releasing function.

The LED 110 is located between a recess of the housing 112 serving as the base and the spacer 108. The spacer 108 is attached to the recess of the housing 112 with the spacer fixing screws 106 and 107, so that a portion of the LED 110 is pressed against and fixed to the surface of the recess of the housing 112 by the spacer 108. The opposite side of the housing 112 from the side having the LED 110 fixed thereto is a cylindrical portion, and this cylindrical portion is covered with the cap 116. A through hole into which the light guiding rod 104 is to be inserted is formed in the central portion of the spacer 108.

The light guiding rod 104 is formed with a transparent medium having a refractive index n (n > 1), or more specifically, with a material such as polymethylmethacrylate (PMMA), polycarbonate (PC), or silica glass. The light guiding rod 104 is a cylindrical structure that has an incident surface 201 facing the LED 110, and a side surface 202 substantially perpendicular to the incident surface 201. The incident surface 201 and the side surface 202 of the light guiding rod 104 are mirror-finished. The light guiding rod 104 has a recessed surface 204 facing the incident surface 201, and a reflecting member 206 formed with a white coating, for example, is provided on the recessed surface 204. At the portion in contact with the spacer 108, the light guiding rod 104 is bonded to the spacer 108 with an adhesive. The LED 110 and the light guiding rod 104 are at a distance from each other, with the spacer 108 existing in between.

The cover 102 is provided at a side portion of the light guiding rod 104 on the side of the incident surface 201, and this cover 102 is fixed to the housing 112 with the cover fixing screws 114 and 115. A light absorbing portion 302 is formed on the surface of the cover 102 facing the light guiding rod 104. This light absorbing portion 302 will be described later in detail. An air layer 130 exists between the light absorbing portion 302 and the side surface 202 of the light guiding rod 104. As the light absorbing portion 302 is provided, leakage light reflected and scattered by the corner portions of the light guiding rod 104 can be blocked. The light absorbing portion 302 is formed with a material that absorbs light, such as a matte-black coating, black alumite, a black plating, black paper, a black sheet, black alumina, black silicon, or black plastic.

The light guiding rod 104 and the cover 102 are covered with the globe 100, and are contained in the globe 100. The globe 100 is bonded and fixed to the housing 112 with an adhesive, for example. The recessed surface 204 of the light guiding rod 104 is located at the center of the globe 100.

In the LED lighting device of the third embodiment, the housing (socket) 112 has a heat releasing function, and the LED 110, the light guiding rod 104, and the globe 100 are fixed integrally to the housing 112 by the spacer 108, the cover 102, the screws 114 and 115, and the like. Thus, an LED lighting device integrally formed with a housing having a heat releasing function can be obtained

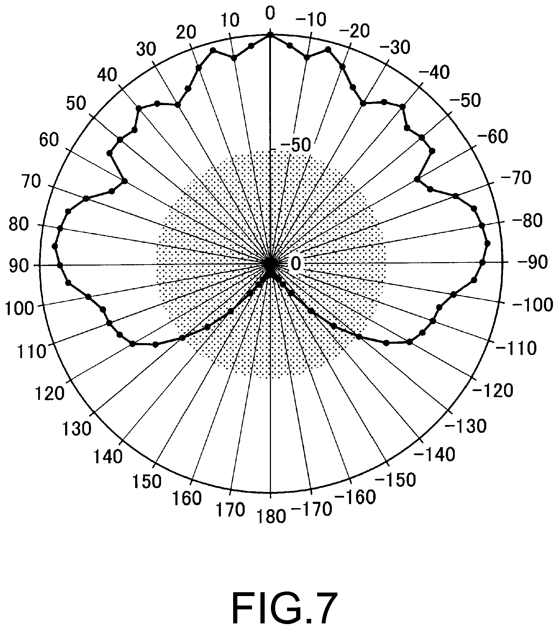

FIG. 7 shows the light distribution of the LED lighting device of the third embodiment having the above structure. In FIG. 7, the direction of the central axis 210 of the light guiding rod 104 of the LED lighting device is set as the 0-degree direction, and the angle between the directional vector of each light ray and the directional vector of the central axis 210 is set as a light distribution angle. FIG. 7 shows the light distribution as the distribution of light intensities with respect to the respective light distribution angles on a radar chart.

Next, the effects of the third embodiment are described.

From the recessed surface 204, light rays are emitted to the outside in all directions. With this, a secondary light source is formed on the recessed surface 204, and lighting like a conventional filament bulb can be realized.

A ray tracing simulation was performed on the LED lighting device 1 of the third embodiment. As a result, the light usage efficiency was 93.6%, and the 1/2 light distribution angle was 260 degrees. Thus, LED lighting with a high efficiency and a wide light distribution can be realized.

Further, the luminance of the LED 110 and the luminance of the LED lighting device 1 of the third embodiment are substantially the same, and it is possible to achieve the effect of reducing decreases in luminance. Particularly, if the globe 100 is transparent, the secondary light source formed on the recessed surface 204 can be clearly seen. Thus, it is possible to improve the aesthetic appearance.

As described above, the third embodiment can provide an LED lighting device capable of preventing decreases in luminance.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1. An optical element comprising:

an incident surface facing a light source;
a side surface intersecting with the incident surface; and
a recessed surface facing the incident surface and intersecting with the side surface, the recessed surface having a shape protruding toward the incident surface,
wherein
the recessed surface includes: a first surface through which a central axis connecting a central portion of the incident surface and a central portion of the recessed surface extends; a second surface joined to the first surface; and a third surface joined to the second surface and to the side surface, and
r represents a distance from the central portion of the incident surface to a rim of the incident surface, n represents a refractive index of the optical element, and a distance L from the recessed surface to the incident surface along the central axis satisfies the following condition:

$$L \geq \frac{2r}{\sqrt{n^2 - 1}}$$

2. An optical element comprising:

an incident surface facing a light source;
a side surface intersecting with the incident surface; and
a recessed surface facing the incident surface and intersecting with the side surface, the recessed surface having a shape protruding toward the incident surface,

wherein

the recessed surface includes: a first surface through which a central axis connecting a central portion of the incident surface and a central portion of the recessed surface extends; a second surface joined to the first surface; and a third surface joined to the second surface and to the side surface,

on the recessed surface, an incident angle of a light ray entering the third surface from the central portion of the incident surface is not smaller than a critical angle,

the recessed surface has a region where an incident angle of a light ray entering the second surface from a point on a rim of the incident surface is not smaller than a critical angle; and

the recessed surface satisfies the condition that there exists a light ray that is totally reflected by the side surface after entering the incident surface, and has a smaller incident angle than a critical angle on the second surface.

3. The optical element according to claim 1 or 2, wherein the second surface and the third surface have at least one pair of normal lines different from each other.

4. The optical element according to any of claims 1 through 3, wherein an outward normal line of the second surface is designed so that an angle to the central axis becomes smaller as a distance from the first surface becomes longer.

5. The optical element according to any of claims 1 through 4, wherein a point at which a straight line extending along the central axis from one point of the rim of the incident surface intersects with the recessed surface is located on a connecting portion between the second surface and the third surface.

6. The optical element according to any of claims 1 through 5, wherein the first surface and the second surface are smoothly joined to each other.

7. The optical element according to any of claims 1 through 6, wherein an area including a portion at which the third surface intersects with the side surface has such a shape that an area of a cross-section perpendicular to the central axis becomes smaller as a distance from the incident surface becomes longer.

8. The optical element according to any of claims 2 through 7, wherein the first surface satisfies the conditions that

an incident angle of a light ray entering the first surface from a point on the rim of the incident surface is not smaller than a critical angle, and

there exists a light ray that is totally reflected by the side surface after entering the incident surface, and has a smaller incident angle than a critical angle on the first surface.

9. The optical element according to any of claims 1 through 8, further comprising

a flange portion provided on a portion of the side surface, the portion being located on a side of the incident surface.

10. The optical element according to any of claims 1 through 9, wherein the side surface has a shape curved outward from the central axis.

11. The optical element according to any of claims 1 through 10, wherein a member that reflects light is provided on the third surface.

12. An LED lighting device comprising

a light source including an LED;

the optical element according to any of claims 1 through 11; and

a globe covering the optical element.

13. The LED lighting device according to claim 12, further comprising

a housing having a heat releasing function,

wherein the light source, the optical element, and the globe are integrated with the housing.

204

206

104

202

201

110

FIG.1

# FIG.2

204  206

208

207

209

202

104A

201

# FIG.3A

FIG.3B

FIG.3C

FIG.3D

FIG.3E

# FIG.4

1

100

204

112

FIG.5

FIG.6

FIG.7

210

409

402

FIG.8

FIG.9

FIG.10

## FIG.11

## INTERNATIONAL SEARCH REPORT

| | International application No. |
|---|---|
| | PCT/JP2016/079360 |

### A. CLASSIFICATION OF SUBJECT MATTER

*F21S2/00*(2016.01)i, *F21V8/00*(2006.01)i, *F21V29/503*(2015.01)i, *G02B5/10*
(2006.01)i, *G02B6/00*(2006.01)i, *G02B17/08*(2006.01)i, *H01L33/00*(2010.01)i,
*H01L33/58*(2010.01)i, *H01L33/60*(2010.01)i, *F21Y115/10*(2016.01)n

According to International Patent Classification (IPC) or to both national classification and IPC

### B. FIELDS SEARCHED

Minimum documentation searched (classification system followed by classification symbols)

F21S2/00, F21V8/00, F21V29/503, G02B5/10, G02B6/00, G02B17/08, H01L33/00,
H01L33/58, H01L33/60, F21Y115/10

Documentation searched other than minimum documentation to the extent that such documents are included in the fields searched

| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y<br><br>A | JP 2012-514842 A   (Koninklijke Philips<br>Electronics N.V.),<br>28 June 2012 (28.06.2012),<br>paragraphs [0027] to [0034], [0041] to [0047],<br>[0049]; fig. 1a to 5<br>& US 2011/0267835 A1<br>paragraphs [0035] to [0041], [0048] to [0054],<br>[0056]; fig. 1a to 5<br>& WO 2010/079391 A1       & KR 10-2011-0106921 A<br>& CN 102272514 A | 1,3-4,6-7,<br>9-13<br>2,5,8 |

☒ Further documents are listed in the continuation of Box C.　　☐ See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 28 November 2016 (28.11.16) | 13 December 2016 (13.12.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (January 2015)

**INTERNATIONAL SEARCH REPORT**

International application No.

PCT/JP2016/079360

C (Continuation).　　DOCUMENTS CONSIDERED TO BE RELEVANT

| Category* | Citation of document, with indication, where appropriate, of the relevant passages | Relevant to claim No. |
|---|---|---|
| Y<br>A | JP 2014-63614 A　(Toshiba Corp.),<br>10 April 2014 (10.04.2014),<br>paragraphs [0003], [0006], [0012] to [0017];<br>fig. 1 to 2<br>& US 2015/0192258 A1<br>paragraphs [0004], [0017], [0022] to [0027];<br>fig. 1 to 2<br>& WO 2014/046019 A1　　& EP 2899457 A1<br>& CN 104583671 A | 1,3-4,6-7,<br>9-13<br>2,5,8 |
| Y<br>A | JP 2015-11897 A　(Toshiba Corp.),<br>09 January 2015 (09.01.2015),<br>paragraphs [0011] to [0012], [0019]; fig. 1<br>(Family: none) | 9-13<br>2,5,8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6350041 B1